# EUROPÄISCHE PATENTSCHRIFT

(11) **EP 1 970 717 B1**
(45) Veröffentlichungstag und Bekanntmachung des Hinweises auf die Patenterteilung: **02.08.2017**
(21) Anmeldenummer: 08450032.1
(22) Anmeldetag: 12.03.2008
(51) Int. Cl.: G01R 31/02, G09G 3/00

(54) **Schaltung und Verfahren zur Spannungsversorgung von Elektrolumineszenz-Folien**
Circuit and method for supplying voltage to electroluminescent foils
Circuit et procédé d'alimentation en tension de feuilles électroluminescentes

(30) Priorität: 14.03.2007 AT 4052007
(43) Veröffentlichungstag der Anmeldung: 17.09.2008
(73) Patentinhaber: Lunatone Industrielle Elektronik GmbH, 1220 Wien (AT)
(72) Erfinder: Mair, Alexander, 2285 Breitstetten (AT)
(74) Vertreter: Patentanwaltskanzlei Matschnig & Forsthuber OG

(56) Entgegenhaltungen:
- WO-A-80/00038
- WO-A-03/073798
- GB-A- 1 302 354
- GB-A- 2 207 540
- GB-A- 2 277 418
- US-A- 5 828 222
- US-A1- 2002 196 030
- US-A1- 2003 160 618
- US-A1- 2006 190 785

## Beschreibung

Die Erfindung bezieht sich auf ein Verfahren zum Feststellen eines Ableitstroms einer durch eine Wechselspannungsquelle gespeisten Last mit signifikantem kapazitiven Anteil.

Ebenso bezieht sich die Erfindung auf eine Schaltung zur Spannungsversorgung von Elektrolumineszenz-Folien.

Bei der Versorgung einer Last mit ausgeprägtem kapazitiven Lastanteil, wie beispielsweise Elektrolumineszenz-Leuchtfolien, wird je nach Größe der Folie und der erforderlichen Leuchtdichte beispielsweise eine Wechselspannung im Frequenzbereich von 100 bis 2000 Hz und eine Versorgungsspannung an der Folie beispielsweise zwischen 40 und 160 V verwendet.

In Hinblick auf die vergleichsweise hohe Spannung kann es in manchen Fällen gewünscht sein, einen Schutz gegen Stromschläge zu schaffen, insbesondere wenn die Folie zerstört wird und dadurch Elektrodenflächen zugängig werden.

Im Zusammenhang mit der Stromversorgung von Leuchtdiodenarrays ist aus der WO 03/073798 A1 eine Schutzschaltung bekannt geworden, welche die Aufgabe hat, fehlerhafte Zustände eines Arrays festzustellen, um eine Beschädigung des Display oder des Speisegerätes abzuwenden. Zu diesem Zweck wird der Versorgungsstrom vorübergehend und kurzzeitig abgeschaltet und eine Einrichtung 50 misst das Verhalten der Last 20, wobei ein Strom durch eine besondere eigene Stromquelle 34 (V_{cc}) eingespeist wird und aus der gemessenen Spannung an der Last geschlossen wird, ob ein reines Halbleiterverhalten vorliegt oder ein solches nicht mehr gegeben ist.

Es wird somit nicht von vorne herein ein signifikanter kapazitiver Anteil vorausgesetzt, dessen abweichender Ableitstrom (verursacht etwa durch Personenberührung) zu messen ist, sondern es geht um die Deformation der Kennlinie der Halbleiteranordnung der Last. Die Messung an der Last erfolgt ausgehend von einer eigenen (Hilfs-)Spannungsquelle, nicht jedoch ausgehend von der einer Trennung im Stromnulldurchgang an der Last verbleibenden Versorgungsspannung.

Das Dokument DE 38 14 251 C1 betrifft eine verhältnismäßig einfache Schaltung, welche eine kapazitive Last, die nicht näher definiert ist, von einem Starkstromnetz dann abschalten soll, wenn in diesem Netz Störimpulse mit steilen Anstiegsflanken auftreten, beispielsweise herrührend vom Abschalten von Maschinen etc.. Ein abschalten wird dann durchgeführt, wenn der ständig gemessene Laststrom einen bestimmten Wert übersteigt und/oder die Netzspannung einen bestimmten Wert übersteigt. Insgesamt stellt die beschriebene Anordnung nichts anderes als eine flinke Sicherung mit einer Wiedereinschaltmöglichkeit der Last dar.

Aus dem Dokument GB-A-2 277 418 geht eine Vorrichtung hervor, mit welcher einzelne Segmente einer LCD-Anzeige auf Fehler überprüft werden sollen, nämlich auf Kurzschlüsse oder Unterbrechungen. Dazu wird das jeweilige Segment von seiner Versorgungsspannung elektrisch getrennt und die Spannung an dem Segment beobachtet. Liegt diese unterhalb eines bestimmten Pegels oder fällt sie innerhalb einer gewissen Zeit unter diesen Pegel, so wird ein Fehlersignal abgegeben.

Das Dokument betrifft somit eine Fehlererkennung, behandelt jedoch nicht die Problematik der Erkennung von Ableitströmen, die für Personen gefährlich sein können.

Eine Aufgabe der Erfindung liegt darin, bei der Versorgung von Lasten mit ausgeprägtem kapazitiven Anteil mit Wechselspannung eine Lösung zu finden, die ein Abschalten der Stromversorgung in kürzester Zeit ermöglicht, wenn ein vollständiger oder teilweiser Nebenschluss durch äußere Einflüsse, insbesondere durch die Berührung von Personen erfolgt.

Diese Aufgabe wird mit einem Verfahren der eingangs genannten Art gemäß Anspruch 1 gelöst. Ebenso wird die Aufgabe mit einer Schaltung zur Spannungsversorgung von Elektrolumineszenz-Folien gemäß Anspruch 3 gelöst. Die Erfindung bietet den Vorteil, dass eine Last ohne wesentliche Unterbrechung der Stromversorgung betrieben werden kann und dennoch das Erkennen von Ableitströmen durch unerwünschte Ableitwiderstände möglich ist. Insbesondere ermöglicht die Erfindung den sicheren Betrieb von Elektrolumineszenz-Folien.

Falls die Messung im Wesentlichen in einem Hochpunkt der Wechselspannung beginnt, kann ein schädlicher Ableitwiderstand besonders rasch festgestellt werden. Als einfache Lösung kann dabei vorgesehen sein, dass die Wechselspannungsquelle ein gesteuerter Wechselrichter ist, dessen Schalter von einem Mikroprozessor angesteuert sind. Auch kann vorgesehen sein, dass der Mikroprozessor dazu eingerichtet ist, durch Öffnen der Schalter die Wechselspannungsversorgung der Elektrolumineszenz-Folie zumindest für eine kurze Zeitspanne zu unterbrechen.

Die Erfindung samt weiteren Vorteilen ist im Folgenden anhand von Ausführungsbeispielen näher erläutert, die in der Zeichnung veranschaulicht sind. In dieser zeigen
Fig.1 eine Prinzipschaltung der Spannungsversorgung einer RC-Last mit Wechselspannung,
Fig. 2 anhand eines Spannungs- und Strom-Zeitdiagramms das Prinzip des erfindungsgemäßen Verfahrens und
Fig. 3 das Prinzipschaltbild einer praktisch angewendeten Spannungsversorgung für eine Elektrolumineszenz-Folie unter Benutzung der Erfindung.

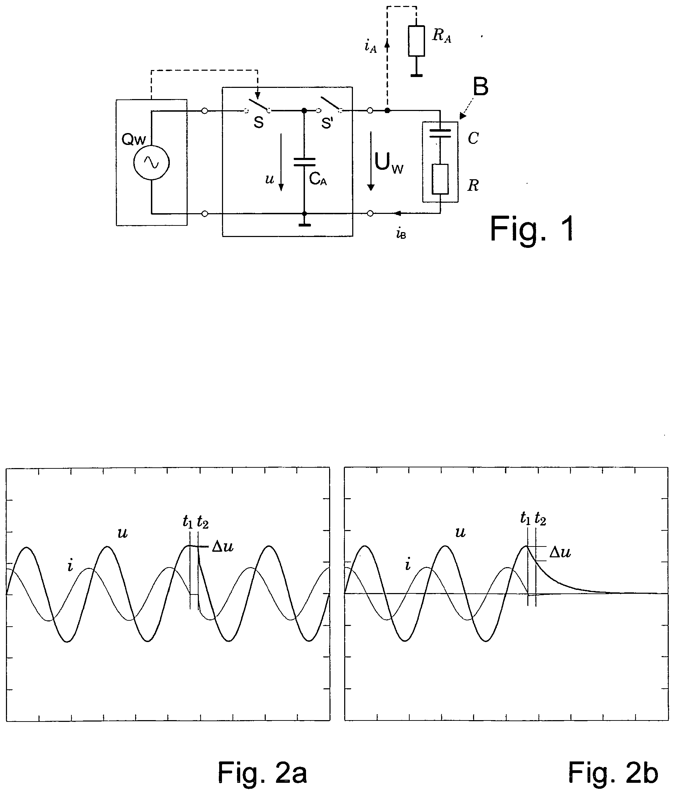

Fig. 1 zeigt eine Wechselspannungsquelle Qw, die über einen Schalter S an eine Last B gelegt werden kann, wobei die Last B aus der Serienschaltung eines Kondensators C und eines Widerstandes R besteht. Im folgenden wird von einer Last mit signifikantem kapazitiven Anteil gesprochen, wie dies beispielsweise für die eingangs genannten Elektrolumineszenz-Folien gilt, deren Ersatzschaltbild in erster Näherung die Serienschaltung eines Widerstandes und eines Kondensators darstellt. Am Ausgang der Wechselspannungsquelle liegt hier noch ein Ausgangskondensator C_{A}, beispielsweise ein Siebkondensator. Der Laststrom ist mit i_{B} bezeichnet.

Im Fehlerfall kann über einen Ableitwiderstand R_{A} ein Ableitstrom i_{A} fließen, dessen Pfad strichliert eingezeichnet ist. Es gilt, einen solchen Laststrom rasch zu erkennen und sein weiteres Fließen zu verhindern, um beispielsweise gesundheitliche Schäden einer Person, deren Körper oder Körperteil dann durch den Ableitwiderstand repräsentiert ist, zu verhindern. Im Folgenden wird das Prinzip des Verfahrens nach der Erfindung unter weiterer Bezugnahme auf die Fig. 2a und 2b erläutert.

Wie Fig. 2a zeigt, wird während des Betriebes zu einem Zeitpunkt t1 der Schalter S geöffnet, wobei dies in vielen Anwendungsfällen zweckmäßigerweise im Nulldurchgang des Laststromes i_{B} oder alternativ in einem Hochpunkt der Spannung erfolgt, wobei zu beachten ist, dass der Laststrom i_{B} gegen die Spannung Uw zufolge des stark kapazitiven Lastanteils gegen die Spannung phasenverschoben ist. Die Spannung an den Klemmen der Last sinkt nun, natürlich umso rascher, je kleiner der Ableitwiderstand R_{A} ist. Im Betrieb einer Lumineszenz-Folie wird der Ableitwiderstand R_{A} im ungestörten Normalzustand zumindest im Bereich von MΩ liegen, wogegen dieser Widerstand bei Berührung spannungsführender Lastteile in den Bereich von beispielsweise unter 50 kΩ sinkt. Der Spannungsabfall ΔU der bis zu einem zweiten Zeitpunkt t2 auftritt wird gemessen und mit einem vorgebbaren Referenzwert verglichen. Falls der Spannungsabfall ΔU diesen Referenzwert übersteigt, wird ein Fehlerzustand angenommen und entsprechende Maßnahmen eingeleitet, wie die Abgabe eines Fehlersignals und/oder sofortiges Abschalten der Spannungsversorgung, was dadurch erfolgen kann, dass der Schalter S nicht mehr geschlossen wird. Dieser Fall ist in Fig. 2b dargestellt. Anderenfalls wird der Schalter nach der Zeit t2 - t1 wieder geschlossen und der Betrieb geht ungestört weiter, wie Fig. 2a zeigt. Es hat sich gezeigt, dass die Zeitspanne Δt = t2 - t1 während des Betriebes einer Elektrolumineszenz-Folie so kurz gehalten werden kann, dass keine sichtbare Unterbrechung feststellbar ist.

Je nach Frequenz der Wechselspannung Uw wird das Verhältnis der Zeitdauer Δt zur Periodendauer T der Wechselspannung ausfallen, wobei in Praxis oft schon 2 ms ausreichend sind, um einen Fehlerzustand erkennen zu können.

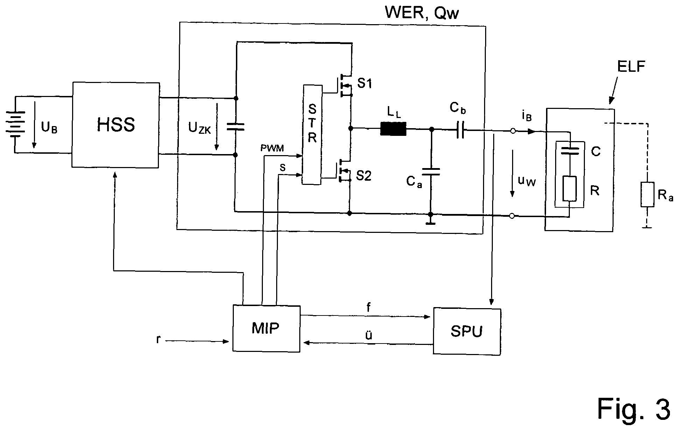

Im Folgenden wird auf Fig. 3 Bezug genommen, welche ein praktisches Ausführungsbeispiel an Hand der Spannungsversorgung einer Elektrolumineszenz-Folie zeigt. Eine Gleichspannung U_{B} von z. B. 12 V speist einen Hochsetzsteller HSS, an dessen Ausgang im Betrieb eine Zwischenkreisspannung U_{zk} beispielsweise 200 V liegt. Von dieser Zwischenkreisspannung wird ein Wechselrichter WER gespeist, der im Prinzip zwei gesteuerte Schalter S1, S2, eine Längsinduktivität L_{L}, einen Querkondensator Cₐ (entsprechend dem Ausgangskondensator in Fig.1), einen Auskoppelkondensator C_{b} und einen Schaltertreiber STR aufweist.

Ein Mikroprozessor MIP liefert ein mit einem vorgebbaren Muster pulsbreitenmoduliertes Signal p an den Schaltertreiber STR, das so beschaffen ist, dass der Wechselrichter eine Ausgangs-Wechselspannung Uw von beispielsweise 120 V mit einer Frequenz von 400 Hz und, im allgemeinen, zumindest angenäherter Sinusform liefert. Derartige Hochsetzsteller und Wechselrichtern stehen dem Fachmann zur Verfügung und gehören dem Stand der Technik an.

Die Ausgangsspannung Uw wird durch eine Überwachungsschaltung SPU überwacht, welche ein Informationssignal i an den Mikroprozessor MIP liefert. Andererseits kann der Mikroprozessor MIP Steuersignale m an die Überwachungsschaltung SPU senden.

Die Ausgangsspannung speist Uw eine Elektrolumineszenz-Folie ELF, deren Ersatzschaltbild in erster Näherung als die Serienschaltung eines Kondensators C mit einem Widerstand R angegeben werden kann.

Um festzustellen, ob Ableitströme vorliegen, die möglicherweise ihren Grund in der Berührung spannungsführender Teile durch eine Person haben und die auf eine Beschädigung des Folienaufbaues zurückgehen können, wird während des Betriebes der Elektrolumineszenz-Folie ELF in kurzen Abständen, z. B. periodisch, in Abständen von 20 ms, eine Messung, wie oben beschrieben durchgeführt. Dazu schaltet wird seitens des Mikroprozessors MIP dem Schaltertreiber ein entsprechender Befehl gegeben, sodass beide Schalter S1 und S2 zu einem Zeitpunkt t1 geöffnet werden. Nun tritt die Spannungsüberwachung SPU auf den Plan, sie misst bis zu einem Zeitpunkt t2, somit über eine Zeitspanne Δt, den Spannungsabfall ΔU der nach dem Abschalten an den Versorgungsklemmen der Elektrolumineszenz-Folie ELF liegenden Spannung (siehe Fig. 2a), wobei die Zeitspanne durch entsprechende Steuersignale m des Mikroprozessors MIP vorgegeben werden kann.

Falls der genannte Spannungsabfall kleiner als ein vorgebbarer Referenzwert ΔUᵣ, entsprechend einem großen Ableitwiderstand R_{A}, der z. B. eine Personengefährdung ausschließt, geht der Betrieb des Wechselrichters WER weiter bis zur nächsten Überprüfung (Fig.2a). Liegt andererseits der Spannungsabfall ΔU über dem Referenzwert ΔUᵣ, so werden über ein Fehlersignal i, allgemein Informationssignal i der Spannungsüberwachung SPU und über den Mikroprozessor MIP und ein Schaltsignal s für die Schaltersteuerung STR die beiden gesteuerten Schalter S1, S2 auch weiterhin offen gehalten und damit ist die Spannungsversorgung der Elektrolumineszenz-Folie ELF unterbrochen, bis beispielsweise ein gegenseitiger Befehl über ein externes Rücksetzsignal r an den Mikroprozessor gegeben wird.

Es soll weiters festgehalten werden, dass im Rahmen der Erfindung ein Ableitstrom bzw. ein entsprechender Ableitwiderstand nicht nur durch eine Spannungsmessung, nämlich durch die Messung des Spannungsabfalls innerhalb einer bestimmten Zeitspanne, überprüft werden kann, sondern dass es auch möglich ist, zu einem bestimmten Zeitpunkt die eigentliche Spannungsquelle von der Last, z. B. der Elektrolumineszenz-Folie, zu trennen, jedoch dafür zu sorgen, dass an den Lastklemmen die zuletzt vorhanden gewesene Spannung festgehalten wird. Für eine gewisse Zeitspanne Δt ist somit die Energiezufuhr zur Last unterbrochen und der Lastkondensator C entlädt sich merklich, falls ein Ableitwiderstand R_{A} vorhanden ist, was beispielsweise bei Berührung spannungsführender Teile durch eine Person gegeben ist.

Wird nun nach der genannten Zeitspanne die Wechselspannungsquelle wieder aufgeschaltet, was beispielsweise bei der Schaltung nach Fig. 3 durch Wiedereinsetzen des Wechselrichterbetriebs bei jener Spannung, bei welcher unterbrochen wurde, geschehen kann, so wird der nun auftretende Einschaltstrom io durch die Last umso größer sein, je kleiner der Ableitwiderstand R_{A} war bzw. ist. Falls nun dieser Einschaltstrom einen Referenzwert i₀ᵣ überschreitet, so wird ein Fehlersignal abgegeben, bzw. kann durch dieses Fehlersignal die Wechselspannungsquelle endgültig von der Last abgeschaltet werden.

Eine andere Möglichkeit zum Festhalten der Spannung wäre die Einführung eines Schalters S' in der Schaltung nach Fig. 1, welcher ebenso wie der Schalter S zu Beginn der Messung geöffnet wird, wobei nach einer Zeitspanne Δt lediglich der Schalter S' geschlossen wird und nun die zuletzt vorhandene Spannung auf dem Kondensator C_{A} einen Einschaltstrom io durch die Last erzeugt, wobei die Größe des Einschaltstroms io wieder mit einem Referenzwert verglichen werden kann und der Schalter S, welcher die Wechselspannungsquelle Uw anschaltet, nicht mehr geschlossen wird, falls der Einschaltstrom io über einem Referenzwert ior gelegen ist.

## Patentansprüche

1. Verfahren zum Feststellen eines Ableitstroms einer durch eine Wechselspannungsquelle gespeisten Last mit signifikantem kapazitiven Anteil, wobei die besagte Last eine Elektrolumineszenz-Folie (ELF) ist, wobei die Spannungsquelle zumindest für eine kurze Zeitspanne (Δt) von der Last getrennt wird und an den Lastklemmen der Spannungsverlauf beobachtet wird,
**dadurch gekennzeichnet, dass**
die Differenz (ΔU) der Spannung zu Beginn (t1) der Zeitdauer und der Spannung am Ende (t2) der Zeitdauer ermittelt und bei Überschreiten der Differenz über einen Referenzwert (ΔUᵣ) ein Fehlersignal (i) abgegeben wird, von dem ausgehend die Wechselspanungsquelle (Q_{w}) von der Last (B, ELF) abgeschaltet bleibt.

2. Verfahren nach Anspruch 1, **dadurch gekennzeichnet, dass** die Messung im Wesentlichen in einem Hochpunkt der Wechselspannung (Uw) beginnt.

3. Schaltung zur Spannungsversorgung von Elektrolumineszenz-Folien, welche Schaltung eine steuerbare Wechselspannungsquelle (Qw+S, WER) für eine Elektrolumineszenz-Folie (ELF), eine Spannungsüberwachung (SPU) und eine Schalteranordnung umfasst, wobei für die an der Elektrolumineszenz-Folie (ELF) liegende Spannung die Spannungsüberwachung (SPU) vorgesehen ist, welche dazu eingerichtet ist, die Spannungsquelle zumindest für eine kurze Zeitspanne (Δt) von der Elektrolumineszenz-Folie zu trennen und den Spannungsverlauf zu beobachten,
**dadurch gekennzeichnet, dass**
die Spannungsüberwachung (SPU) darüber hinaus eingerichtet ist, die Differenz (ΔU) der Spannung zu Beginn (t1) der Zeitdauer und der Spannung am Ende (t2) der Zeitdauer zu ermitteln und bei Überschreiten der Differenz über einen Referenzwert (ΔUᵣ) ein Fehlersignal (i) abzugeben, wobei durch das Fehlersignal (i) über die Schalteranordnung (S; S1, S2) die Wechselspannungsquelle (Q_{w}) von der Elektrolumineszenz-Folie (B, ELF) abgeschaltet bleibt.

4. Schaltung nach Anspruch 3, **dadurch gekennzeichnet, dass** die Wechselspannungsquelle (Qw, WER) ein gesteuerter Wechselrichter ist, dessen Schalter (S1, S2) von einem Mikroprozessor (MIP) angesteuert sind.

5. Schaltung nach Anspruch 4, **dadurch gekennzeichnet, dass** der Mikroprozessor (MIP) dazu eingerichtet ist, durch Öffnen der Schalter (S1, S2) die Wechselspannungsversorgung der Elektrolumineszenz-Folie (ELF) zumindest für eine kurze Zeitspanne (Δt) zu unterbrechen.

## Claims

1. Process for determination of the leakage current of a load fed via an AC voltage source with a significant capacitive component, whereby the aforesaid load is an electro-luminescent film (ELF), and whereby the voltage source is separated from the load at least for a short time (Δt) and observed on the load terminals of the voltage curve,
**characterised by the fact that**
the difference (ΔU) in voltage at the start (t1) of the time period and the voltage at the end (t2) of the time period is determined, and if with regard to a reference value (ΔUᵣ) the difference is exceeded an error signal (i) is output, from which the AC voltage source (Qw) remains deactivated from the load (B, ELF).

2. Process in accordance with claim 1, **characterised by the fact that** the measurement essentially starts at a high point of the AC voltage (Uw).

3. Circuit for power supply of electro-luminescent films, said circuit comprising a controllable AC voltage source (Qw+S, WER) for an electro-luminescent film (ELF), a voltage monitoring (SPU) and a switch layout, with the voltage monitoring (SPU) intended for the voltage applied to the electro-luminescent film (ELF), this monitoring being set up for separating the voltage source at least for a short time period (Δt) from the electro-luminescent film and for observing the voltage curve,
**characterised by the fact that**
the voltage monitoring (SPU) is also set up to determine the difference (ΔU) in voltage at the start (t1) of the time period to the voltage at the end (t2) of the time period and if with regard to a reference value (ΔUᵣ) the difference is exceeded an error signal (i) is output, whereby due to the error signal (i) via the switch layout (S; S1, S2) the AC voltage source (Qw) remains deactivated from the electro-luminescent film (B, ELF).

4. Circuit in accordance with claim 3, **characterised by the fact that** the AC voltage source (Qw, WER) is a controlled inverter, the switches (S1, S2) of which are controlled by a microprocessor (MIP).

5. Circuit in accordance with claim 4, **characterised by the fact that** the microprocessor (MIP) is set up for interrupting the AC voltage supply of the electro-luminescent film (ELF) for at least a short time period (Δt) via opening of the switches (S1, S2).

## Revendications

1. Procédé de détermination d'un courant de fuite d'une charge alimentée par une source de tension alternative ayant une part capacitive significative, la charge en question étant un film électroluminescent (ELF), la source de tension étant coupée de la charge pendant au moins un bref laps de temps (Δt) et étant surveillée aux bornes de charge de la courbe de tension,
**caractérisé en ce que**
la différence (ΔU) de la tension est déterminée au début (t1) de la durée et à la fin (t2) de la durée, et au cas où la différence dépasse une certaine valeur de référence (ΔUᵣ), un signal d'erreur (i) est émis, valeur à partir de laquelle la source de tension alternative (Qw) reste déconnectée de la charge (B, ELF).

2. Procédé selon la revendication 1, **caractérisé en ce que** la mesure commence pour l'essentiel à un point haut de la tension alternative (U_{W}).

3. Circuit pour l'alimentation en tension de films électroluminescents, circuit qui comprend une source de tension alternative manoeuvrable (Qw+S, WER) pour un film électroluminescent (ELF), une surveillance de la tension (SPU) et un dispositif à commutateurs, sachant que la surveillance de la tension (SPU) est conçue pour la tension appliquée sur le film électroluminescent (ELF), ce circuit étant aménagé pour couper pendant au moins un bref laps de temps (Δt) la source de tension du film électroluminescent et pour surveiller la courbe de tension, **caractérisé en ce que** la surveillance de la tension (SPU) est conçue par ailleurs en vue de déterminer la différence (ΔU) entre la tension au début (t1) de la durée et la tension à la fin (t2) de la durée, et au cas où la différence dépasse une certaine valeur de référence (ΔUᵣ) un signal d'erreur (i) est émis, si bien que la source de tension alternative (Qw) du film électroluminescent (B, ELF) reste déconnectée par le signal d'erreur (i) transmis par le dispositif à commutateurs (S; S1, S2).

4. Circuit selon la revendication 3, **caractérisé en ce que** la source de tension alternative (Qw, WER) est un onduleur commandé dont le commutateur (S1, S2) est commandé par un microprocesseur (MIP).

5. Circuit selon la revendication 4, **caractérisé en ce que** le microprocesseur (MIP) est conçu de telle façon que l'alimentation en tension alternative du film électroluminescent (ELF) est coupée, au moins pour un bref laps de temps (Δt), par l'ouverture des commutateurs (S1, S2)
